# EUROPÄISCHE PATENTSCHRIFT

(11) **EP 3 665 871 B1**
(45) Veröffentlichungstag und Bekanntmachung des Hinweises auf die Patenterteilung: **21.07.2021**
(21) Anmeldenummer: 18749365.5
(22) Anmeldetag: 01.08.2018
(51) Int. Cl.: H04L 12/40, H03K 5/1534, H04B 3/20, H04L 25/02, H04L 25/03

(54) **SENDE-/EMPFANGSEINRICHTUNG FÜR EIN BUSSYSTEM UND VERFAHREN ZUR REDUZIERUNG EINER SCHWINGNEIGUNG BEIM ÜBERGANG ZWISCHEN UNTERSCHIEDLICHEN BITZUSTÄNDEN**
TRANSCEIVER FOR A BUS SYSTEM, AND METHOD FOR REDUCING AN OSCILLATION INCLINATION UPON TRANSITIONING BETWEEN DIFFERENT BIT STATES
ÉQUIPEMENT ÉMETTEUR/RÉCEPTEUR POUR UN SYSTÈME DE BUS ET PROCÉDÉ DE RÉDUCTION D'UNE TENDANCE AUX OSCILLATIONS LORS DU PASSAGE ENTRE DES ÉTATS DE BITS DIFFÉRENTS

(30) Priorität: 08.08.2017 DE 102017213834
(43) Veröffentlichungstag der Anmeldung: 17.06.2020
(73) Patentinhaber: Robert Bosch GmbH, 70442 Stuttgart (DE)
(72) Erfinder: PANNWITZ, Axel, 01445 Radebeul (DE); WALKER, Steffen, 72770 Reutlingen (DE); BRANDO, Cyrille, 72654 Neckartenzlingen (DE)
(86) Internationale Anmeldenummer: PCT/EP2018/070910
(87) Internationale Veröffentlichungsnummer: WO 2019/030081

(56) Entgegenhaltungen:
- JP-A- 2017 050 839
- US-A1- 2010 124 298
- US-A1- 2016 036 604

## Beschreibung

Die vorliegende Erfindung betrifft eine Sende-/Empfangseinrichtung für ein Bussystem und ein Verfahren zur Reduzierung einer Schwingneigung beim Übergang zwischen unterschiedlichen Bitzuständen, welche beispielsweise bei einer Teilnehmerstation für ein CAN-Bussystem zum Einsatz kommen können. Die Reduzierung der Schwingneigung wird für eine vorbestimmte Zeit ein Kurzschluss zwischen Busadern eines Busses des Bussystems erzeugt.

### Stand der Technik

Bei einer Nachrichten- oder Datenübertragung in einem Bussystem werden Informationen, die in Bytes bzw. Bits der Nachrichten oder Daten enthalten sind, durch unterschiedliche Bitzustände oder Spannungszustände dargestellt. Die unterschiedlichen Bitzustände haben beim Übertragen der Nachricht über einen Bus des Bussystems unterschiedliche Buszustände zur Folge. Je nach Bussystem existieren für Nachrichten- oder Datenübertragung verschiedene Übertragungsprotokolle.

Beispielsweise werden beim CAN-Bussystem Nachrichten mittels des CAN- und/oder CAN FD Protokolls übertragen, wie es im Standard ISO-11898-1:2015 als CAN Protokoll-Spezifikation mit CAN FD beschrieben ist. Das CAN-Bussystem ist heute für die Kommunikation zwischen Sensoren und Steuergeräten weit verbreitet. Oft wird das CAN-Bussystem in Fahrzeugen oder Automatisierungsanlagen, usw. für eine Kommunikation zwischen den einzelnen Busteilnehmern eingesetzt.

Insbesondere bei der CAN/CAN-FD-Kommunikation müssen die Sende-/Empfangseinrichtungen, die auch Transceiver genannt werden, in der Lage sein, den Bus niederohmig treiben zu können, um einen dominanten Buszustand oder Bitzustand als einen der beiden verschiedenen Buszustände oder Bitzustände herzustellen. Im Rezessivzustand als dem anderen der beiden verschiedenen Buszustände dagegen sind die Sende-/Empfangseinrichtungen verhältnismäßig hochohmig.

Der Übergang von Dominant nach Rezessiv ist je nach Bustopologie, Länge der Stubs bzw. Stichleitungen, Position und Anzahl der Terminationswiderstände mit einer Schwingneigung behaftet. Dies ist sehr unvorteilhaft bei der Systemauslegung, weil infolgedessen die Bitzeit so lang sein muss, bis die Schwingung ausreichend bedämpft ist. Ist die Bitzeit nicht lang genug, kann die Sende-/Empfangseinrichtung im Rezessivzustand fälschlicherweise ein Dominant erkennen. Daher bedingt eine Einhaltung der maximal zulässigen Fehlerquote der Sende-/Empfangseinrichtung eine längere Bitzeit, was eine unerwünschte Reduzierung der Übertragungsrate oder Übertragungsgeschwindigkeit der Nachrichten im Bussystem zur Folge hat.

Die Offenlegungsschrift US 2016/036604 A1 offenbart eine Schaltung zur differenziellen Signalübertragung über einen zweidrahtigen Bus, welche neben der üblichen Transceiver-Funktionalität eine Schaltung umfasst, mit der neben dem normalen Zustand ein zweiter Zustand mit niedriger Impedanz hergestellt werden kann, indem ein Widerstand zwischen die beiden Busleitungen geschaltet wird.

US 2010/124298 A1 offenbart eine Sende-/Empfangseinrichtung für ein Bussystem, bei der die Sendeeinrichtung in einem sendenden Betriebszustand in bestimmten Zeitabschnitten einen Kurzschluss zwischen den Busleitungen erzeugen kann.

JP 2017 050839 A offenbart eine weitere Sende-/ Empfangseinrichtung für ein Bussystem.

### Offenbarung der Erfindung

Daher ist es Aufgabe der vorliegenden Erfindung, eine Sende-/Empfangseinrichtung für ein Bussystem und ein Verfahren zur Reduzierung einer Schwingneigung beim Übergang zwischen unterschiedlichen Bitzuständen bereitzustellen, welche die zuvor genannten Probleme lösen. Insbesondere sollen eine Sende-/Empfangseinrichtung für ein Bussystem und ein Verfahren zur Reduzierung einer Schwingneigung beim Übergang zwischen unterschiedlichen Bitzuständen oder Spannungszuständen, insbesondere einer Schwingneigung beim Übergang vom dominanten zum rezessiven Zustand, in einem Bussystem bereitgestellt werden.

Die Aufgabe wird durch eine Sende-/Empfangseinrichtung für ein Bussystem mit den Merkmalen von Anspruch 1 gelöst.

Mit der beschriebenen Sende-/Empfangseinrichtung ist eine Reduzierung der Schwingdauer oder ein sogenanntes Ringing Suppression beim Übergang von Dominant nach Rezessiv möglich, woraus eine Erhöhung der Bitraten folgt, insbesondere im Datenbereich einer Nachricht. Als Folge davon steigt die Übertragungsrate oder Übertragungsgeschwindigkeit der Nachrichten im Bussystem.

Zudem erlaubt eine Reduzierung der Schwingdauer beim Übergang zwischen unterschiedlichen Bitzuständen oder Spannungszuständen, insbesondere beim CAN-Bussystem von Dominant nach Rezessiv, mehr Freiheit bei der Auslegung von Bustopologien und/oder von Abschlüssen und/oder von Stubs und/oder von der Anzahl der Knoten bzw. Teilnehmerstationen des Bussystems.

Noch dazu wird durch die beschriebene Ausgestaltung der Sende-/Empfangseinrichtung eine vorteilhafte Veränderung des Spektrums bei leitungsgebundener Emission erzielt. Die Abstrahlung von Emissionen kann nämlich im kritischen Frequenzbereich verringert werden, der beispielsweise zwischen ein und drei MHz liegt, was der Resonanzfrequenz aus Gleichtaktdrossel und parasitären Kapazitäten entspricht. Stattdessen tritt durch die beschriebene Schwingungsreduktionseinheit die Abstrahlung von Emissionen in dem unkritischen Frequenzbereich auf, der bei dem genannten Beispiel bei Frequenzen größer als 10MHz liegt, und bei dem die Drossel wirkt.

Die Sende-/Empfangseinrichtung ist für alle Kommunikationssysteme geeignet, bei welchen ein Buszustand aktiv getrieben wird, wie insbesondere bei einem CAN-Bussystem, einem CAN-HS-Bussystem, einem CAN-FD-Bussystem, usw. Bei einem CAN-HS-Bussystem (HS = Hochgeschwindigkeit = Highspeed) ist eine Datenübertragungsrate von bis zu 500 kBit pro Sekunde (500 kbps) möglich. Bei einem CAN FD-Bussystem ist eine Datenübertragungsrate von größer 1 MBit pro Sekunde (1Mbps) möglich.

Vorteilhafte weitere Ausgestaltungen der Sende-/Empfangseinrichtung sind in den abhängigen Ansprüchen beschrieben.

Gemäß einer Ausgestaltung weist die Schwingungsreduktionseinheit einen Transistor auf, der an einem Anschluss zwischen den ersten Treiber und die ersten Busader angeschlossen ist und an einem weiteren Anschluss zwischen den zweiten Treiber und die zweite Busader angeschlossen ist, und einen Ansteuerblock, welcher ausgestaltet ist, den Transistor zumindest leitend zu schalten während eines Zustandswechsels des Signals auf mindestens einer der Busadern von einem dominanten Buszustand zu einem rezessiven Buszustand.

Gemäß einer speziellen Ausgestaltung ist der Ansteuerblock zudem ausgestaltet, einen Zustandswechsel des Signals auf mindestens einer Busader von dem dominanten Buszustand zu dem rezessiven Buszustand zu erfassen

Möglicherweise hat die Schwingungsreduktionseinheit zum Erzeugen des Kurzschlusses einen Transistor, der als Hochvolt-NMOS-Transistor ausgestaltet ist.

Gemäß einer speziellen Ausgestaltung ist der Ansteuerblock zudem ausgestaltet, unterschiedliche Phasen einer Kommunikation auf dem Bus zu erfassen und das Signal auf mindestens einer Busader in Abhängigkeit von der erfassten Phase der Kommunikation auf dem Bus zu steuern. Hierbei kann der Ansteuerblock ausgestaltet sein, ein Endebit zu erfassen, welches das Ende einer Nachricht anzeigt, um die unterschiedlichen Phasen einer Kommunikation auf dem Bus zu erfassen, und/oder wobei der Ansteuerblock ausgestaltet ist, das Signal auf mindestens einer Busader nach Abschluss einer Arbitrationsphase der Kommunikation zu steuern.

Gemäß noch einer Ausgestaltung ist es möglich, dass die Sende-/Empfangseinrichtung nur aktiviert ist, wenn der erste Treiber und/oder der zweite Treiber ein Signal auf den Bus treibt.

Die zuvor beschriebene Sende-/Empfangseinrichtung kann Teil einer Teilnehmerstation für das Bussystem sein, die zudem eine Kommunikationssteuereinrichtung zum Steuern einer Kommunikation der Teilnehmerstation mit mindestens einer weiteren Teilnehmerstation des Bussystems aufweist, wobei die Sende-/Empfangseinrichtung zum Senden von Nachrichten auf den Bus des Bussystems und zum Empfangen von Nachrichten von dem Bus ausgestaltet ist. Hierbei kann die Kommunikationssteuereinrichtung oder die Sende-/Empfangseinrichtung einen Block aufweisen, welcher ausgestaltet ist, einen Zustandswechsel eines vom Bus empfangenen Signals von dem dominanten Buszustand zu dem rezessiven Buszustand zu erfassen, wobei die Schwingungsreduktionseinheit ausgestaltet ist, den Kurzschluss zwischen den Busadern in Abhängigkeit von dem Erfassungsergebnis des Blocks zu erzeugen.

Zudem kann die Kommunikationssteuereinrichtung ausgestaltet sein, ein Signal an die Sende-/Empfangseinrichtung zu senden, welches die Sende-/Empfangseinrichtung als Grundlage für die Signale für die Busadern verwendet, und das Signal mit einem von der Sende-/Empfangseinrichtung vom Bus empfangenen Signal zur Erzeugung eines Steuersignals zu vergleichen, und wobei die Kommunikationssteuereinrichtung ausgestaltet ist, das Steuersignal zur Steuerung der Schwingungsreduktionseinheit an die Sende-/Empfangseinrichtung auszugeben.

Die zuvor beschriebene Teilnehmerstation kann Teil eines Bussystems sein, das einen Bus, und mindestens zwei Teilnehmerstationen aufweist, welche über den Bus derart miteinander verbunden sind, dass sie miteinander kommunizieren können. Hierbei weist mindestens eine der mindestens zwei Teilnehmerstationen eine zuvor beschriebene Sende-/Empfangseinrichtung auf.

Die zuvor genannte Aufgabe wird zudem durch ein Verfahren zur Reduzierung einer Schwingneigung beim Übergang zwischen unterschiedlichen Bitzuständen mit den Merkmalen von Anspruch 10 gelöst. Das Verfahren wird mit einer Sende-/Empfangseinrichtung für ein Bussystem ausgeführt, bei welchem zumindest zeitweise ein exklusiver, kollisionsfreier Zugriff einer Teilnehmerstation auf einen Bus des Bussystems gewährleistet ist, wobei die Sende-/Empfangseinrichtung einen ersten Treiber zum Treiben eines ersten Signals für eine erste Busader des Busses und einen zweiten Treiber zum Treiben eines zweiten Signals für die zweite Busader des Busses aufweist, wobei das Verfahren den Schritt aufweist: Erzeugen, mit einer Schwingungsreduktionseinheit, eines Kurzschlusses zumindest während eines Zustandswechsels des Signals auf mindestens einer der Busadern von einem dominanten Buszustand zu einem rezessiven Buszustand.

Das Verfahren bietet dieselben Vorteile, wie sie zuvor in Bezug auf die Sende-/Empfangseinrichtung genannt sind.

Weitere mögliche Implementierungen der Erfindung umfassen auch nicht explizit genannte Kombinationen von zuvor oder im Folgenden bezüglich der Ausführungsbeispiele beschriebenen Merkmale oder Ausführungsformen. Dabei wird der Fachmann auch Einzelaspekte als Verbesserungen oder Ergänzungen zu der jeweiligen Grundform der Erfindung hinzufügen.

### Zeichnungen

Nachfolgend ist die Erfindung unter Bezugnahme auf die beiliegende Zeichnung und anhand von Ausführungsbeispielen näher beschrieben. Es zeigen:
Fig. 1 ein vereinfachtes Blockschaltbild eines Bussystems gemäß einem ersten Ausführungsbeispiel;
Fig. 2 ein elektrisches Schaltbild eines Senders einer Sende-/Empfangseinrichtung des Bussystems gemäß dem ersten Ausführungsbeispiel;
Fig. 3A einen zeitlichen Verlauf eines Sendesignals TxD bei der Sende-/Empfangseinrichtung gemäß dem ersten Ausführungsbeispiel sowie Fig. 3B einen zeitlichen Verlauf eines Sendesignals TxD bei einer herkömmlichen Sende-/Empfangseinrichtung;
Fig. 4A einen zeitlichen Verlauf der Bussignale CAN_H und CAN_L bei der Sende-/Empfangseinrichtung gemäß dem ersten Ausführungsbeispiel sowie Fig. 4B einen zeitlichen Verlauf der Bussignale CAN_H und CAN_L bei der herkömmlichen Sende-/Empfangseinrichtung;
Fig. 5A einen zeitlichen Verlauf einer Differenzspannung VDIFF der Bussignale CAN_H und CAN_L bei der Sende-/Empfangseinrichtung gemäß dem ersten Ausführungsbeispiel sowie Fig. 5B einen zeitlichen Verlauf der Differenzspannung VDIFF der Bussignale CAN_H und CAN_L bei der herkömmlichen Sende-/Empfangseinrichtung;
Fig. 6A einen zeitlichen Verlauf einer Empfängerausgabe bei der Sende-/Empfangseinrichtung gemäß dem ersten Ausführungsbeispiel sowie Fig. 6B einen zeitlichen Verlauf einer Empfängerausgabe bei der herkömmlichen Sende-/Empfangseinrichtung;
Fig. 7A einen zeitlichen Verlauf eines Empfangssignals RxD bei der Sende-/Empfangseinrichtung gemäß dem ersten Ausführungsbeispiel sowie Fig. 7B einen zeitlichen Verlauf eines Empfangssignals RxD bei einer herkömmlichen Sende-/Empfangseinrichtung;
Fig. 8 ein Schaubild zur Veranschaulichung des Aufbaus einer Nachricht, die von einer Teilnehmerstation des Bussystems gemäß dem ersten Ausführungsbeispiel gesendet wird; und

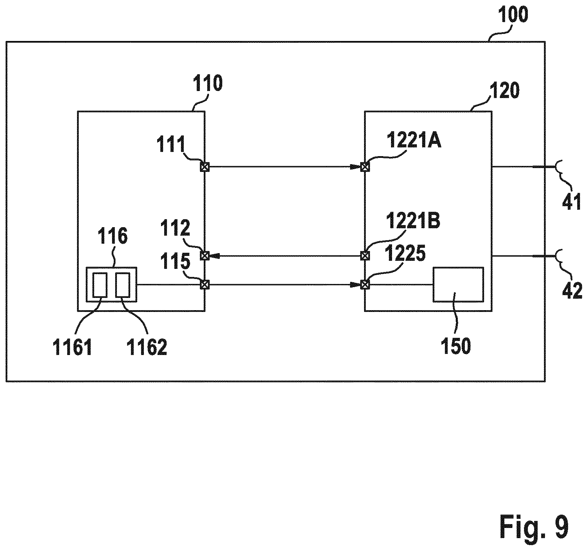

Fig. 9 ein elektrisches Schaltbild einer Sende-/Empfangseinrichtung eines Bussystems gemäß einem zweiten Ausführungsbeispiel.

In den Figuren sind gleiche oder funktionsgleiche Elemente, sofern nichts anderes angegeben ist, mit denselben Bezugszeichen versehen.

### Beschreibung der Ausführungsbeispiele

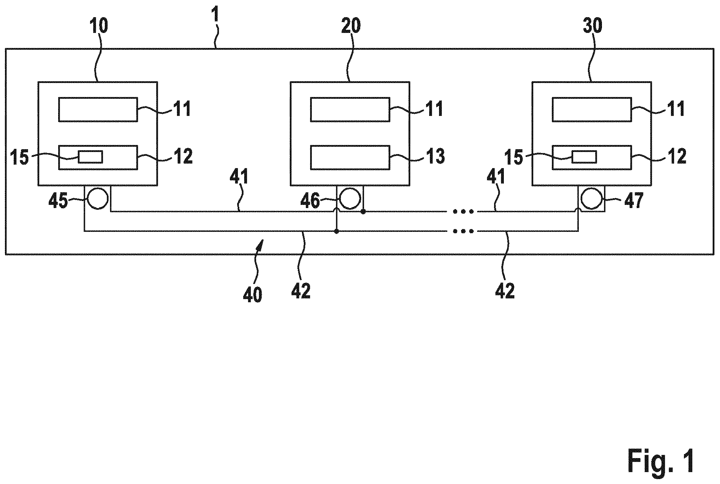

Fig. 1 zeigt ein Bussystem 1, das beispielsweise zumindest abschnittsweise ein CAN-Bussystem, ein CAN-FD-Bussystem, usw., sein kann. Das Bussystem 1 kann in einem Fahrzeug, insbesondere einem Kraftfahrzeug, einem Flugzeug, usw., oder im Krankenhaus usw. Verwendung finden.

In Fig. 1 hat das Bussystem 1 eine Vielzahl von Teilnehmerstationen 10, 20, 30, die jeweils an einen Bus 40 mit einer ersten Busader 41 und einer zweiten Busader 42 angeschlossen sind. Die Busadern 41, 42 können auch CAN_H und CAN_L genannt werden und dienen zur elektrischen Signalübertragung nach Einkopplung der dominanten Pegel bzw. Erzeugung von rezessiven Pegeln für ein Signal im Sendezustand. Über den Bus 40 können Nachrichten 45, 46, 47 in der Form von Signalen zwischen den einzelnen Teilnehmerstationen 10, 20, 30 übertragen werden. Die Teilnehmerstationen 10, 20, 30 können beispielsweise Steuergeräte oder Anzeigevorrichtungen eines Kraftfahrzeugs sein.

Wie in Fig. 1 gezeigt, haben die Teilnehmerstationen 10, 30 jeweils eine Kommunikationssteuereinrichtung 11 und eine Sende-/Empfangseinrichtung 12. Die Sende-/Empfangseinrichtungen 12 umfassen jeweils eine Schwingungsreduktionseinheit 15. Die Teilnehmerstation 20 hat dagegen eine Kommunikationssteuereinrichtung 11 und eine Sende-/Empfangseinrichtung 13. Die Sende-/Empfangseinrichtungen 12 der Teilnehmerstationen 10, 30 und die Sende-/Empfangseinrichtung 13 der Teilnehmerstation 20 sind jeweils direkt an den Bus 40 angeschlossen, auch wenn dies in Fig. 1 nicht dargestellt ist.

Die Kommunikationssteuereinrichtung 11 dient zur Steuerung einer Kommunikation der jeweiligen Teilnehmerstation 10, 20, 30 über den Bus 40 mit einer anderen Teilnehmerstation der an den Bus 40 angeschlossenen Teilnehmerstationen 10, 20, 30. Die Sende-/Empfangseinrichtung 12 dient zum Senden der Nachrichten 45, 47 in Form von Signalen und nutzt hierbei die Schwingungsreduktionseinheit 15, wie später noch ausführlicher beschrieben. Die Kommunikationssteuereinrichtung 11 kann insbesondere wie ein herkömmlicher CAN-FD-Controller und/oder CAN-Controller ausgeführt sein. Die Sende-/Empfangseinrichtung 13 kann insbesondere wie ein herkömmlicher CAN-Transceiver und/oder CAN-FD-Transceiver ausgeführt sein. Die Sende-/Empfangseinrichtung 13 kann insbesondere wie ein herkömmlicher CAN-Transceiver ausgeführt sein.

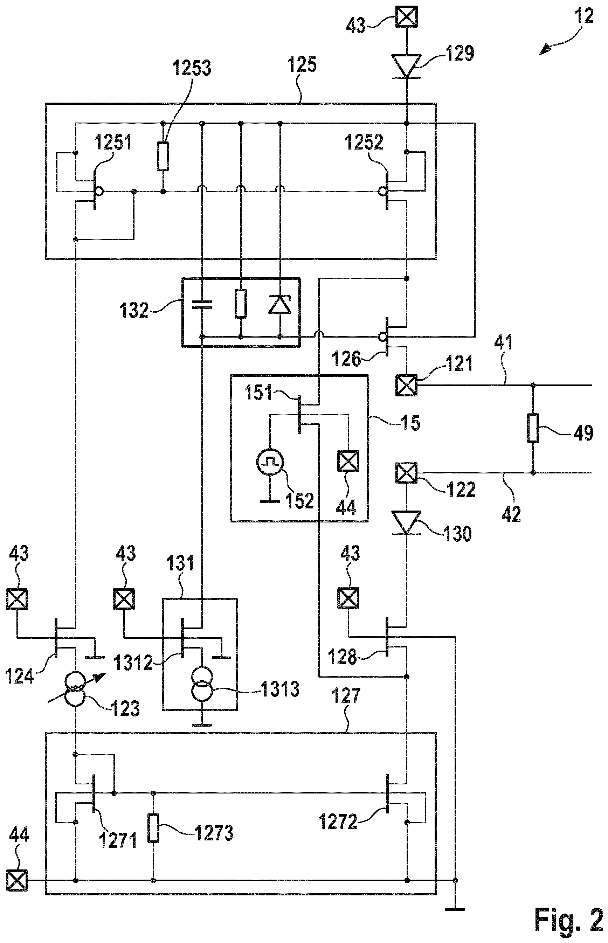

Fig. 2 zeigt den grundlegenden Aufbau eines Senders der Sende-/Empfangseinrichtung 12 mit der Schwingungsreduktionseinheit 15. Auch wenn nachfolgend immer von der Sende-/Empfangseinrichtung 12 gesprochen wird, ist es alternativ möglich, einen Empfänger in einer separaten Einrichtung extern von dem Sender vorzusehen. Der Empfänger kann wie bei einer herkömmlichen Sende-/Empfangseinrichtung 12 aufgebaut sein.

Die Sende-/Empfangseinrichtung 12 ist an den Bus 40, genauer gesagt dessen erste Busader 41 für CAN_H und dessen zweite Busader 42 für CAN_L angeschlossen. Die Spannungsversorgung, insbesondere CAN-Supply, für die erste und zweite Busader 41, 42 erfolgt über mindestens einen Anschluss 43. Die Verbindung mit Masse bzw. CAN_GND ist über einen Anschluss 44 realisiert. Die erste und zweite Busader 41, 42 sind mit einem Abschlusswiderstand 49 terminiert.

Die erste und zweite Busader 41, 42 sind an die Sende-/Empfangseinrichtung 12 an Anschlüssen 121, 122 angeschlossen. In Bezug auf den Sender, der auch als Transmitter bezeichnet wird, hat die Sende-/Empfangseinrichtung 12 Komponenten 123 bis 132 zum Senden von Signalen auf die erste und zweite Busader 41, 42. In Bezug auf den Empfänger, der auch als Receiver bezeichnet wird, ist für die Sende-/Empfangseinrichtung 12 in Fig. 2 keine der Komponenten zum Behandeln von Signalen gezeigt, die von der ersten und zweiten Busader 41, 42 empfangen werden.

Was den Sender betrifft, kann zu den Anschlüssen 121, 122 mit Hilfe einer regelbaren Stromquelle 123 und eines Kaskodetransistors 124 ein Signal CAN_H für die erste Busader 41 über einen ersten Stromspiegel 125 und einen ersten Endstufen-Transistor 126 getrieben werden. Der Transistor 124 hat eine feste Gatespannung, die gleich der Spannung am Anschluss 43 ist. Zudem kann mit Hilfe der regelbaren Stromquelle 123 und des Transistors 124 ein Signal CAN_L für die zweite Busader 42 über einen zweiten Stromspiegel 127 und einen zweiten Endstufen-Transistor 128 getrieben werden. Somit gibt die regelbare Stromquelle 123 die Ausgangsflanken vor, aus welchen von den jeweiligen Stromspiegeln 125, 127 Flanken für die zugehörigen Busadern 41, 42 erzeugt werden. Die regelbare Stromquelle 123 wird mit Hilfe eines Sendesignals TxD von der Kommunikationssteuereinrichtung 11 gesteuert. Daher bilden die Komponenten 123, 124, 125 einen ersten Treiber, der zum Treiben eines Signals CAN_H für die erste Busader 41 ausgestaltet ist. Die Komponenten 123, 124, 127 bilden einen zweiten Treiber, der zum Treiben eines Signals für die zweite Busader 42 ausgestaltet ist.

Für den ersten Stromspiegel 125 ist eine Verpolschutzdiode 129 vorgesehen, die zwischen dem ersten Stromspiegel 125 und dem Anschluss 43 angeschlossen ist. Hierbei ist die Anode der Verpolschutzdiode 129 an dem Anschluss 43 angeschlossen. Für den zweiten Stromspiegel 127 ist eine Verpolschutzdiode 130 zwischen einem Source-Anschluss des zweiten Endstufen-Transistors 128 und dem Anschluss 122 für die zweite Busader 42 vorgesehen.

Der erste Stromspiegel 125 weist Transistoren 1251, 1252 auf, die an ihrem Gate-Anschluss elektrisch miteinander verbunden sind. Die beiden Transistoren 1251, 1252 sind außerdem an ihren Source-Anschlüssen elektrisch miteinander verbunden. Zwischen den Gate-Anschlüssen und den Source-Anschlüssen der beiden Transistoren 1251, 1252 ist ein Widerstand 1253 angeschlossen. Der erste Stromspiegel 125 ist bei dem vorliegenden Beispiel als PMOS-Stromspiegel ausgeführt. Daher sind die Transistoren 1251, 1252 jeweils PMOS-Transistoren, die üblicherweise auch als p-Kanal-MOSFET bezeichnet werden, wobei MOSFET für Metall-Oxid-Semiconductor-Feldeffekt-Transistor steht (Semiconductor = Halbleiter).

Der zweite Stromspiegel 127 weist Transistoren 1271, 1272 auf, die an ihrem Gate-Anschluss elektrisch miteinander verbunden sind. Die beiden Transistoren 1271, 1272 sind außerdem an ihren Source-Anschlüssen elektrisch miteinander verbunden. Zwischen den Gate-Anschlüssen und den Source-Anschlüssen der beiden Transistoren 1271, 1272 ist ein Widerstand 1273 angeschlossen. Der zweite Stromspiegel 127 ist bei dem vorliegenden Beispiel als NMOS-Stromspiegel ausgeführt. Daher sind die Transistoren 1271, 1272 jeweils NMOS-Transistoren, die üblicherweise auch als n-Kanal-MOSFET bezeichnet werden.

Der Endstufen-Transistor 126 für die erste Busader 41 ist bei dem vorliegenden Beispiel als Hochvolt -PMOS-Kaskode ausgeführt. Der Endstufen-Transistor 128 für die zweite Busader 42 ist bei dem vorliegenden Beispiel als Hochvolt - NMOS-Kaskode ausgeführt.

Der Sender der Sende-/Empfangseinrichtung 12 hat eine Vorspannungseinheit 131, die einen Transistor 1312 und eine Vorspannungsstromquelle 1312 aufweist. Außerdem hat der Sender der Sende-/Empfangseinrichtung 12 eine Parallelschaltung 132 mit einem Widerstand, einem Kondensator und einer Diode. Die Vorspannungseinheit 131 speist die Parallelschaltung 132 mit einer vorbestimmten Vorspannung oder einem vorbestimmten Vorspannungspotenzial von dem Anschluss 43. Genauer gesagt, erzeugen die Vorspannungseinheit 131 und die Parallelschaltung 132 eine Spannung an dem Gate-Anschluss des Endstufen-Transistors 126. Der Empfänger hat einen nicht dargestellten Empfangskomparator, mit dem von den Busadern 41, 42 ein Empfangssignal RxD, das auch als RxD-Signal bezeichnet wird, empfangen wird und an die Kommunikationssteuereinrichtung 11 weitergegeben wird.

Die Schwingungsreduktionseinheit 15 hat einen Transistor 151 und einen Ansteuerblock 152. Der Transistor 151 ist bei dem vorliegenden Beispiel als Hochvolt -NMOS-Transistor ausgeführt. Die Gate-Elektrode des Transistors 151 ist mit dem Ansteuerblock 152 verbunden. Die Bulk-Elektrode des Transistors 151 ist mit dem Anschluss 44 für Masse verbunden. Die Source-Elektrode ist mit der Verbindung zwischen den beiden Transistoren 126, 1252 verbunden. Die Drain-Elektrode ist mit der Verbindung zwischen den Transistoren 128, 1272 verbunden.

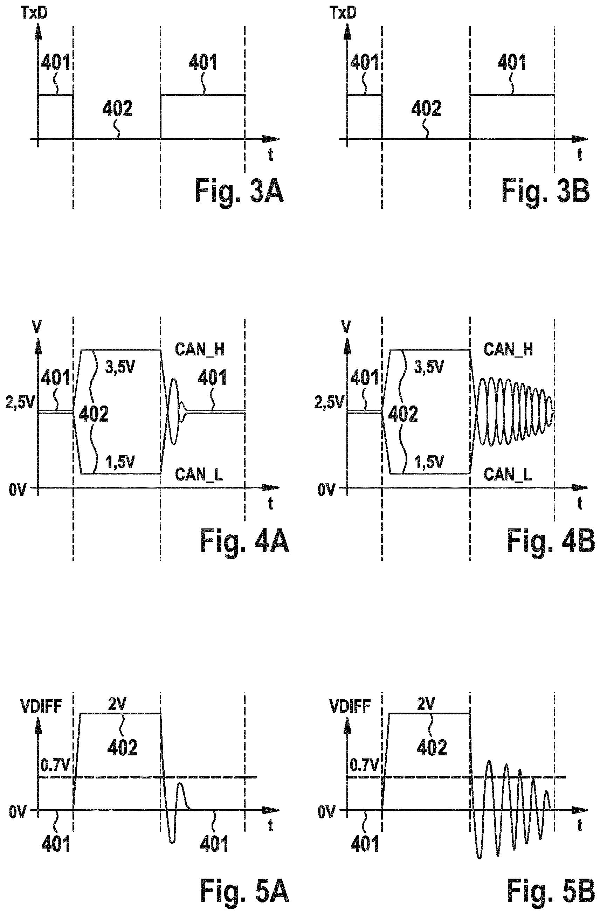

Der Betrieb des Senders der Sende-/Empfangseinrichtung 12 gemäß Fig. 2 ist nachfolgend auch anhand der Signalverläufe von Fig. 3A bis Fig. 7B näher erläutert.

Fig. 3A bis Fig. 7A zeigen jeweils einen zeitlichen Verlauf von Signalen bei der Sende-/Empfangseinrichtung 12 gemäß dem vorliegenden Ausführungsbeispiel.

Hierbei stellen sich in Folge eines in Fig. 3A gezeigten Sendesignals TxD die Signale gemäß Fig. 4A bis Fig. 7A ein.

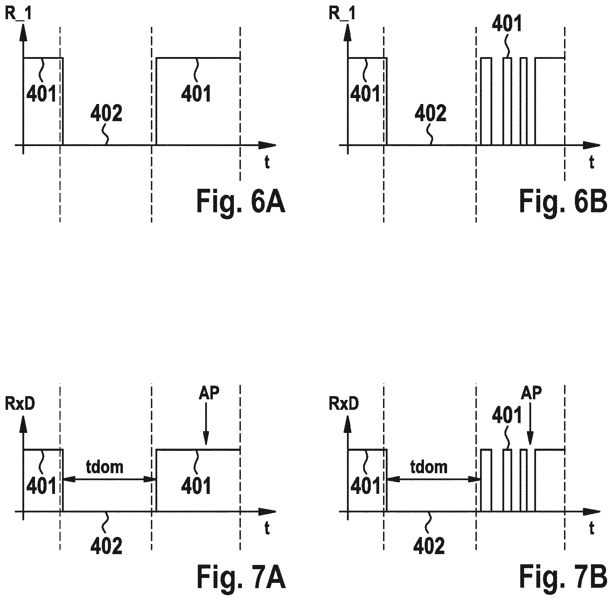

Bei dem Sendesignal TxD von Fig. 3A findet im Laufe der Zeit t bei drei aufeinanderfolgenden Bits ein Zustandswechsel von einem ersten Buszustand 401 zu einem zweiten Buszustand 402 und dann wieder zurück zu dem ersten Buszustand 401 statt. Der erste Buszustand 401 kann auch als Rezessivzustand oder hoher Pegel bezeichnet werden. Der zweite Buszustand 402 kann auch als Dominantzustand oder niedriger Pegel bezeichnet werden. In Folge des Sendesignals TxD von Fig. 3A stellt sich die Spannung V für die Signale CAN_H und CAN_L gemäß Fig. 4A ein, die Differenzspannung VDIFF = CAN_H - CAN_L gemäß Fig. 5A ein, ein Ausgangssignal R_1 des Empfängers 122 gemäß Fig. 6A ein, und ein Empfangssignal RxD gemäß Fig. 7A ein. Die Spannung V für die Signale CAN_H und CAN_L gemäß Fig. 4A entspricht im ersten Buszustand 401 oder rezessiven Zustand der Hälfte des Busvorspannungspotenzials der Busvorspannungseinheit 1223.

Im Vergleich dazu sind in den Fig. 3B bis Fig. 7B jeweils die zeitlichen Verläufe von Signalen bei einer Sende-/Empfangseinrichtung gemäß einer herkömmlichen Sende-/Empfangseinrichtung veranschaulicht, wie beispielsweise der Sende-/Empfangseinrichtung 13 der Teilnehmerstation 20.

Aus dem Vergleich der Signale von Fig. 4A und Fig. 4B ergibt sich sehr deutlich, dass die Sende-/Empfangseinrichtung 12 gemäß dem vorliegenden Ausführungsbeispiel bei demselben Sendesignal TxD ein deutlich schnelleres Einschwingen der Signale CAN-H und CAN_L nach dem Zustandswechsel von dem Zustand 401 auf den Zustand 402 bzw. von Dominant nach Rezessiv bewirkt. Ist die Schwellwertspannung des Empfängers 122 auf den üblichen Wert von 0,7 V eingestellt, wie in Fig. 5A und Fig. 5B veranschaulicht, erkennt der Empfänger 122 auch bei einem Zustandswechsel von dem Zustand 401 auf den Zustand 402 bzw. von Dominant nach Rezessiv keine angeblichen Zustandswechsel mehr von dem Zustand 402 auf den Zustand 401 bzw. von Rezessiv nach Dominant, wie auch in Fig. 6A dargestellt. Somit kann eine Abtastung des Empfangssignals RxD bei dem derzeit üblichen Abtastpunkt AP sicher zu dem gewünschten Ergebnis führen, wie in Fig. 7A dargestellt. Dies gilt, auch wenn sich die Länge der Bitzeit tdom des Zustands 401 bzw. eines dominanten Bits gegenüber einer herkömmlichen Sende-/Empfangseinrichtung oder der Sende-/Empfangseinrichtung 13 der Teilnehmerstation 20 etwas verlängert, wie aus dem Vergleich von Fig. 7A und Fig. 7B ersichtlich.

Somit hat die Sende-/Empfangseinrichtung 12 gemäß dem vorliegenden Ausführungsbeispiel eine geringere Schwingneigung als eine herkömmliche Sende-/Empfangseinrichtung bzw. die Sende-/Empfangseinrichtung 13.

Im Betrieb der Sende-/Empfangseinrichtung 12 von Fig. 2 steuert den Ansteuerblock 152 während eines Schaltvorgangs von einem dominanten Buszustand zu einem rezessiven Buszustand bzw. von einem zweiten Buszustand 402 zu einem ersten Buszustand und bei Bedarf für eine vorbestimmte Zeit darüber hinaus den Kurzschluss-Transistor 151 an. Dadurch wird der Kurzschluss-Transistor 151 leitfähig. Infolgedessen wird durch den Transistor 151 ein Kurzschluss zwischen den Busadern 41, 42 erzeugt. Damit wird das sonst lang andauernde Einschwingen der Differenzspannung VDIFF, wie in Fig. 5B gezeigt, deutlich verkürzt. Der Kurzschluss hat nämlich ein deutlich beschleunigtes Einschwingen nach dem Wechsel von dem Zustand 402 zu dem Zustand 401 zur Folge, wie es in Fig. 5A gezeigt ist. Der Kurzschluss zwischen den Busadern 41, 42 bewirkt, dass die in der Verpolschutzdiode 130 gespeicherte Diffusions-Ladung über den Transistor 128, der eine HV-NMOS-Kaskode ist, schneller abgebaut wird.

Als weiterer positiver Effekt des erzeugten Kurzschlusses werden Reflexionen begrenzt, die bei "realen" Kabelbäumen in einem Fahrzeug, insbesondere einem Kraftfahrzeug, usw., auftreten. Die Reflexionen entstehen durch Fehlanpassungen, Unsymmetrien, etc. Die Reflexionen werden durch den Kurzschluss hinter den Transistoren 126, 128 ebenfalls begrenzt, so dass das Signal CAN_L auf der zweiten Busader 42 nur noch eine Dioden-Flussspannung größer werden kann als das Signal CAN_H auf der ersten Busader 41.

Der Ansteuerblock 152 kann einen Zustandswechsel der Signale CAN_H und/oder CAN_L und/oder der Differenzspannung VDIFF wie folgt erfassen. Ein Wechsel des Buszustands 401 nach 402 bzw. von Dominant nach Rezessiv wird durch den Ansteuerblock 152 erkannt, wenn bei dem TxD-Signal ein Rezessiv-Buszustand bzw. der Buszustand 401 mindestens für die Zeit eines Bits beginnt, wie in Fig. 3A veranschaulicht.

Der Ansteuerblock 152 ist derart ausgestaltet, dass die Zeit der Ansteuerung des Transistors 151 in Bruchteilen der Bitzeit, vorzugsweise stufenlos, einstellbar ist. Die Einstellung kann entweder aufgrund einer Erfassung einer Erfassungseinrichtung im Betrieb der Sende-/Empfangseinrichtung 12 vorgenommen werden oder fest oder, insbesondere von einem Benutzer, konfigurierbar vorgegeben sein.

Somit wird mit der Sende-/Empfangseinrichtung 12 ein Verfahren zur Reduzierung einer Schwingneigung beim Übergang zwischen unterschiedlichen Bitzuständen durchgeführt.

Bei dem beschriebenen Ausführungsbeispiel haben nur die Teilnehmerstationen 10, 30 die Funktionalität der Sende-/Empfangseinrichtung 12. Die Teilnehmerstationen 10, 30 sind vorzugsweise Teilnehmerstationen oder Knoten mit hoher Schwingneigung. Die hohe Schwingneigung der Teilnehmerstationen 10, 30 kann sich insbesondere durch deren Position im Bussystem 1, die Position der Terminationswiderstände 49, die Stub-Länge bzw. Stichleitungslänge zu den Teilnehmerstationen 10, 30, usw. ergeben.

Gemäß einer Modifikation des ersten Ausführungsbeispiels ist die zuvor beschriebene Funktionalität der Sende-/Empfangseinrichtung 12 nur aktiv, wenn die Sende-/Empfangseinrichtung 12 selbst sendet bzw. als Sender agiert.

Gemäß einer weiteren Modifikation des ersten Ausführungsbeispiels hat auch die Teilnehmerstation 20 anstelle einer Sende-/Empfangseinrichtung 13 eine Sende-/Empfangseinrichtung 12. In diesem Fall ist die zuvor beschriebene Funktionalität der Sende-/Empfangseinrichtung 12 für alle Teilnehmerstationen 10, 20, 30 des Bussystems aktiv, insbesondere je nach Bedarf.

Gemäß noch einer weiteren Modifikation des ersten Ausführungsbeispiels kann der Ansteuerblock 152 zusätzlich eine Kommunikationsphase auf dem Bus 40 erfassen und das Erfassungsergebnis bei der Ansteuerung des Transistors 151 mit einbeziehen. Dadurch kann die Ansteuerung des Transistors 151 mittels des Ansteuerblocks 152 zusätzlich abhängig von einer Kommunikationsphase auf dem Bus 40 vorgenommen werden.

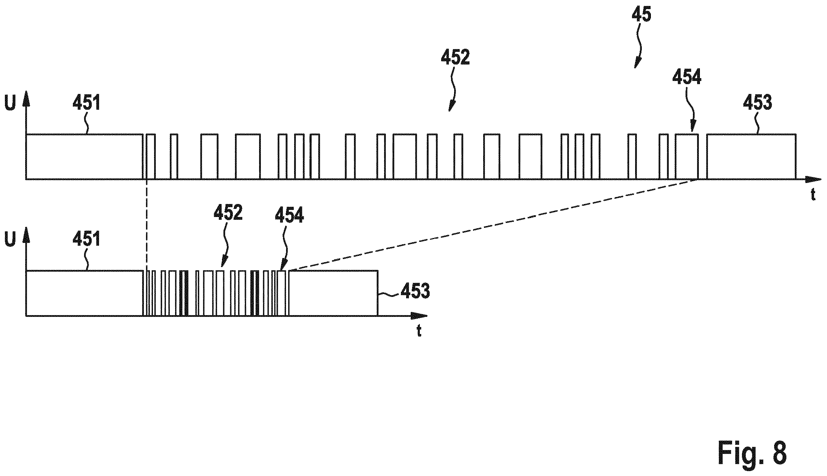

Fig. 8 stellt die unterschiedlichen Phasen einer Kommunikation auf dem Bus 40 dar, welche von dem Ansteuerblock 152 erfasst und erkannt und unterschieden werden können. Fig. 8 zeigt in ihrem oberen Teil anhand der Nachricht 45 einen CAN-Rahmen, wie er von der Sende-/Empfangseinrichtung 12 oder der Sende-/Empfangseinrichtung 13 gesendet wird, und in ihrem unteren Teil einen CAN-FD-Rahmen, wie er von der Sende-/Empfangseinrichtung 12 gesendet werden kann. Der CAN-Rahmen und der CAN-FD-Rahmen sind für die CAN-Kommunikation auf dem Bus 40 grundlegend in zwei unterschiedliche Phasen unterteilt, nämlich die Arbitrationsphasen 451, 453 und einen Datenbereich 452, der bei CAN-HS auch Datenfeld bzw. bei CAN-FD auch Datenphase genannt wird. Der Datenbereich 452 ist an seinem Ende mit mindestens einem Endebit 454 abgeschlossen, das auch EOF genannt wird, wobei EOF für End of Frame bzw. Ende der Nachricht steht. Bei CAN oder CAN FD ist das EOF eine Bitabfolge aus 11 rezessiven Bits, also Bits mit dem zweiten Buszustand 402.

Bei CAN-FD wird im Vergleich zum klassischen CAN am Ende der Arbitrationsphase 451 die Bitrate für die folgende Datenphase auf z. B. 2, 4, 8Mbps erhöht. Damit gilt, dass bei CAN-FD die Bitrate in den Arbitrationsphasen 451, 453 kleiner als die Bitrate im Datenbereich 452 ist. Bei CAN-FD ist der Datenbereich 452 gegenüber dem Datenbereich 452 des CAN-Rahmens deutlich verkürzt.

Die Arbitrationsphasen 451, 453 sind ein wichtiger Bestandteil eines CAN-Rahmens und eines CAN-FD-Rahmens bzw. der Nachrichten 45, 46, 47, die in Fig. 1 gezeigt sind. Dabei wird entschieden, welcher Knoten bzw. welche Teilnehmerstation 10, 20, 30 des Bussystems 1 die wichtigste Nachricht 45, 46, 47 trägt. Die Teilnehmerstation 10, 20, 30 mit der wichtigsten Nachricht 45, 46, 47 gewinnt die Arbitration und darf daher die Nachricht nach Abschluss der Arbitrationsphase senden. Alle anderen Teilnehmerstationen sind dann beim Übertragen dieser wichtigsten Nachricht Zuhörer. Hierbei treiben die Sende-/Empfangseinrichtungen 12, 13 den Bus 40 niederohmig, um einen dominanten Buszustand 402 (Fig. 3A bis Fig. 7A) oder Bitzustand als einen der beiden verschiedenen Buszustände 401, 402 oder Bitzustände herzustellen. Im Rezessivzustand als dem anderen der beiden verschiedenen Buszustände 401, 402 dagegen sind die Sende-/Empfangseinrichtungen 12, 13 verhältnismäßig hochohmig.

Der Ansteuerblock 152 kann die Arbitrationsphasen 451, 453, den Datenbereich 452 sowie das Ende des Datenbereichs 453, also das Endebit (EOF) 54 erkennen. Dadurch kann die Funktionalität der Schwingungsreduktionseinheit 15 je nach Wunsch entweder für alle Kommunikationsphasen 451 bis 453 oder Phasen/Bereiche einer Nachricht 45 gelten oder nur bei abgeschlossener Arbitration, also für den Datenbereich 452. Letzteres ist sinnvoll, wenn ansonsten zu viele Teilnehmerstationen 10, 20, 30 gleichzeitig beim Arbitrieren die Funktion der Sende-/Empfangseinrichtung 12 aktivieren können und damit den effektiven Buswiderstand zu stark reduzieren.

Fig. 10 zeigt den grundlegenden Aufbau einer Teilnehmerstation 100 mit einer Kommunikationssteuereinrichtung 110 und einer Sende-/Empfangseinrichtung 120 gemäß einem zweiten Ausführungsbeispiel. Das Bussystem 1 und die Teilnehmerstation 100 sind bis auf die nachfolgend beschriebenen Unterschiede auf die gleiche Weise aufgebaut, wie zuvor gemäß dem ersten Ausführungsbeispiel oder seinen Modifikationen für das Bussystem 1 und die Teilnehmerstation 10 beschrieben.

Die Kommunikationssteuereinrichtung 110 ist bis auf die nachfolgend beschriebenen Unterschiede aufgebaut wie die Kommunikationssteuereinrichtung 11 des ersten Ausführungsbeispiels. Die Sende-/Empfangseinrichtung 120 ist bis auf die nachfolgend beschriebenen Unterschiede aufgebaut wie die Sende-/Empfangseinrichtung 12 des ersten Ausführungsbeispiels.

Die Kommunikationssteuereinrichtung 110 hat neben den Anschlüssen 111, 112 für die Signale TxD, RxD einen zusätzlichen Anschluss 115 für ein Steuersignal RS_Control_Out.

Die Sende-/Empfangseinrichtung 120 hat einen Anschluss 1221A zum Empfang des Sendesignals TxD von dem Anschluss 111 der Kommunikationssteuereinrichtung 110, wie bereits zuvor in Bezug auf das erste Ausführungsbeispiel allgemeiner beschrieben. Außerdem hat die Sende-/Empfangseinrichtung 120 einen Anschluss 1221B zum Senden des Empfangssignals RxD an den Anschluss 112 der Kommunikationssteuereinrichtung 110, wie bereits zuvor in Bezug auf das erste Ausführungsbeispiel allgemeiner beschrieben. Zusätzlich dazu weist die Sende-/Empfangseinrichtung 120 einen Anschluss 1225 auf, an welchem das Steuersignal RS_Control_Out als Steuersignal RS_Control_In empfangen wird.

Zur Erzeugung des Steuersignals RS_Control_Out für den Anschluss 115 hat die Kommunikationssteuereinrichtung 110 einen Steuerblock 116. Der Steuerblock 116 überwacht den Busverkehr auf den Busadern 41, 42, indem der Steuerblock 116 das als erste Informationen 1161 gespeicherte Sendesignal TxD und das am Anschluss 112 empfangene, und bei Bedarf zwischengespeicherte, Empfangssignal RxD miteinander vergleicht. Treten im rezessiven Buszustand, also dem ersten Buszustand 401, Abweichungen zwischen den beiden Signalen TxD, RxD auf, wie beispielsweise Zustandswechsel im Empfangssignal RxD, die nicht in dem Sendesignal TxD enthalten waren, so können daraus Rückschlüsse über das Netzwerk bzw. den Bus 40 und die Signalintegrität gezogen werden.

Des Weiteren liegen in dem Steuerblock 116 der Kommunikationssteuereinrichtung 110 zweite Informationen 1162 vor, wie Bitrate, Ausbreitungsverzögerung (Propagation-Delay) für beide Schaltvorgänge, also einem Zustandswechsel von dem ersten Buszustand 401 zu dem zweiten Buszustand 402. Die Informationen 1162 können alternativ in einem nicht dargestellten weiteren Block, insbesondere Speicher, vorgehalten werden.

Dabei kann der RxD-Ausgang am Anschluss 1221B anstelle eines Digitalsignals das Ausgangssignal eines Analog-Digital-Wandlers sein, welcher die Differenzspannung des Empfangssignals RxD darstellt.

Unter Berücksichtigung dieser Informationen 1161, 1162 erzeugt der Steuerblock 116 das Steuersignal RS_Control_Out, welches von dem Anschluss 115 ausgegeben wird, an dem Anschluss 1225 der Sende-/Empfangseinrichtung 120 empfangen wird und an die Schwingungsreduktionseinheit 150 weitergegeben wird. Dementsprechend muss bei der Schwingungsreduktionseinheit 150 der Ansteuerblock 152 nicht die Funktion des Erfassens des Signalzustandswechsels und oder der Kommunikationsphase durchführen, die im Bezug auf die Schwingungsreduktionseinheit 15 des vorangehenden Ausführungsbeispiels beschrieben sind.

Auf diese Weise wird die Steuerung der Reduktion der Schwingneigung (Ringing Suppression) hier nicht von der Sende-/Empfangseinrichtung 120 gesteuert, sondern von der Kommunikationssteuereinrichtung 110. Hierbei kann die Kommunikationssteuereinrichtung 110, genauer gesagt ihr Steuerblock 116, die Schwingungsreduktionseinheit 150 an die speziellen Eigenschaften der Teilnehmerstation 100 und des Netzwerks bzw. des Busses 40 anpassen. In anderen Worten, die Kommunikationssteuereinrichtung 110, genauer gesagt ihr Steuerblock 116, kann die Schwingungsreduktionseinheit 150 Knoten- und Netzwerk-Sensitiv einstellen. Der Steuerblock 116 bietet damit eine Lernfunktion für die Teilnehmerstation 100.

Damit kann ebenso eine deutliche Reduktion der Schwingneigung bei dem Zustandswechsel vom zweiten Buszustand 402 zum ersten Buszustand 401 realisiert werden. Zudem kann dadurch ein deutlicher Gewinn für das Bussystem 1 als Gesamtsystem erreicht werden.

Alle zuvor beschriebenen Ausgestaltungen der Schwingungsreduktionseinheiten 15, 150 der Sende-/Empfangseinrichtungen 12, 120 der Teilnehmerstationen 10, 20, 30, 100, des Bussystems 1 und des darin ausgeführten Verfahrens gemäß den Ausführungsbeispielen und deren Modifikationen können einzeln oder in allen möglichen Kombinationen Verwendung finden. Zusätzlich sind insbesondere folgende Modifikationen denkbar.

Das zuvor beschriebene Bussystem 1 gemäß den Ausführungsbeispielen und/oder deren Modifikationen ist anhand eines auf dem CAN-Protokoll basierenden Bussystems beschrieben. Das Bussystem 1 gemäß den Ausführungsbeispielen und/oder deren Modifikationen kann jedoch auch eine andere Art von Kommunikationsnetz sein, beispielsweise eine anderes serielles Bussystem. Es ist vorteilhaft, jedoch nicht zwangsläufige Voraussetzung, dass bei dem Bussystem 1 zumindest für bestimmte Zeitspannen ein exklusiver, kollisionsfreier Zugriff einer Teilnehmerstation 10, 20, 30,100 auf die Busleitung 40 oder einen gemeinsamen Kanal der Busleitung 40 gewährleistet ist.

Das Bussystem 1 gemäß den Ausführungsbeispielen und/oder deren Modifikationen ist insbesondere ein CAN-Netzwerk oder ein CAN-HS-Netzwerk oder ein CAN FD-Netzwerk oder ein FlexRay-Netzwerk. Das Bussystem 1 kann jedoch auch ein anderes serielles Kommunikationssetzwerk sein.

Insbesondere kann die Schwingungsreduktionseinheit 15, 150 bei LVDS (Low Voltage Differential Signaling) eingesetzt werden, der ein Schnittstellen-Standard für eine Hochgeschwindigkeits-Datenübertragung ist, bei welcher ein Sender und ein Empfänger über eine Datenübertragungsstrecke miteinander verbunden sind. LVDS ist standardisiert nach ANSI/TIA/EIA-644-1995.

Die Anzahl und Anordnung der Teilnehmerstationen 10, 20, 30, 100 in dem Bussystem 1 gemäß den Ausführungsbeispielen und/oder deren Modifikationen ist beliebig. Insbesondere können auch nur Teilnehmerstationen 10 oder Teilnehmerstationen 30 oder Teilnehmerstationen 100 in den Bussystemen 1 der Ausführungsbeispiele und/oder deren Modifikationen vorhanden sein.

Die Funktionalität der zuvor beschriebenen Ausführungsbeispiele und/oder deren Modifikationen lässt sich jeweils in einem Transceiver bzw. einer Sende-/Empfangseinrichtung 12 bzw. Transceiver oder einem CAN-Transceiver oder einem Transceiver-Chipsatz oder einem CAN-Transceiver-Chipsatz, usw. umsetzen. Zusätzlich oder alternativ kann es in existierende Produkte integriert werden. Insbesondere ist es möglich, dass die betrachtete Funktionalität entweder im Transceiver als separater elektronischer Baustein (Chip) realisiert oder in einer integrierten Gesamtlösung, bei welchem nur ein elektronischer Baustein (Chip) vorhanden ist, eingebettet ist.

## Patentansprüche

1. Sende-/Empfangseinrichtung (12; 120) für ein Bussystem (1), mit
einem ersten Treiber (123, 124, 125) zum Treiben eines ersten Signals (CAN_H) für eine erste Busader (41) eines Busses (40) des Bussystems (1), bei welchem Bussystem (1) zumindest zeitweise ein exklusiver, kollisionsfreier Zugriff einer Teilnehmerstation (10, 20, 30) auf den Bus (40) des Bussystems (1) gewährleistet ist,
einem zweiten Treiber (123, 124, 127) zum Treiben eines zweiten Signals (CAN_L) für die zweite Busader (42) des Busses (40), und
einer Schwingungsreduktionseinheit (15; 150), die ausgestaltet ist, zumindest während eines Zustandswechsels des Signals (CAN_H, CAN_L) auf mindestens einer der Busadern (41, 42) von einem dominanten Buszustand (402) zu einem rezessiven Buszustand (401) einen Kurzschluss zwischen den Busadern zu erzeugen,
**dadurch gekennzeichnet, dass** mit Hilfe einer regelbaren Stromquelle (123) und eines Kaskodetransistors (124) ein Signal (CAN_H) für die erste Busader (41) über einen ersten Stromspiegel (125) und einen ersten Endstufen-Transistor (126) getrieben wird,
wobei der erste Stromspiegel (125) als PMOS-Stromspiegel ausgeführt ist,
wobei für den ersten Stromspiegel (125) eine erste Verpolschutzdiode (129) vorgesehen ist, die zwischen dem ersten Stromspiegel (125) und einem Anschluss (43) an die Spannungsversorgung angeschlossen ist,
wobei die Anode der ersten Verpolschutzdiode (129) an dem Anschluss (43) angeschlossen ist,
wobei mit Hilfe der regelbaren Stromquelle (123) und des Kaskodetransistors (124) ein Signal (CAN_L) für die zweite Busader (42) über einen zweiten Stromspiegel (127) und einen zweiten Endstufen-Transistor (128) getrieben wird,
wobei der zweite Stromspiegel (127) als NMOS-Stromspiegel ausgeführt ist,
wobei für den zweiten Stromspiegel (127) eine zweite Verpolschutzdiode (130) zwischen einem Source-Anschluss des zweiten Endstufen-Transistors (128) und dem Anschluss (122) für die zweite Busader (42) vorgesehen ist.

2. Sende-/Empfangseinrichtung (12; 120) nach Anspruch 1, wobei die Schwingungsreduktionseinheit (15; 150) aufweist
einen Transistor (151), der an einem Anschluss zwischen den ersten Treiber (123, 124, 125) und die ersten Busader (41) angeschlossen ist und an einem weiteren Anschluss zwischen den zweiten Treiber (123, 124, 127) und die zweite Busader (42) angeschlossen ist, und
einen Ansteuerblock (152), welcher ausgestaltet ist, den Transistor (151) zumindest leitend zu schalten während eines Zustandswechsels des Signals (CAN_H, CAN_L) auf mindestens einer der Busadern (41, 42) von einem dominanten Buszustand (402) zu einem rezessiven Buszustand (401).

3. Sende-/Empfangseinrichtung (12; 120) nach Anspruch 1 oder 2, wobei der Ansteuerblock (152) zudem ausgestaltet ist, einen Zustandswechsel des Signals auf mindestens einer Busader (41, 42) von dem dominanten Buszustand (402) zu dem rezessiven Buszustand (401) zu erfassen.

4. Sende-/Empfangseinrichtung (12; 120) nach einem der vorangehenden Ansprüche, wobei die Schwingungsreduktionseinheit (15; 150) zum Erzeugen des Kurzschlusses einen Transistor (151) aufweist, der als Hochvolt-NMOS-Transistor ausgestaltet ist.

5. Sende-/Empfangseinrichtung (12; 120) nach einem der vorangehenden Ansprüche, wobei der Ansteuerblock (152) zudem ausgestaltet ist, unterschiedliche Phasen einer Kommunikation auf dem Bus (40) zu erfassen und das Signal auf mindestens einer Busader (41; 42) in Abhängigkeit von der erfassten Phase der Kommunikation auf dem Bus (40) zu steuern.

6. Sende-/Empfangseinrichtung (12; 120) nach Anspruch 5,
wobei der Ansteuerblock (152) ausgestaltet ist, ein Endebit (454) zu erfassen, welches das Ende einer Nachricht (45; 47) anzeigt, um die unterschiedlichen Phasen einer Kommunikation auf dem Bus (40) zu erfassen, und/oder
wobei der Ansteuerblock (152) ausgestaltet ist, das Signal auf mindestens einer Busader (41; 42) nach Abschluss einer Arbitrationsphase (451; 453) der Kommunikation zu steuern.

7. Sende-/Empfangseinrichtung (12; 120) nach einem der vorangehenden Ansprüche, wobei die Schwingungsreduktionseinheit (15; 150) derart ausgestaltet ist, dass die Schwingungsreduktionseinheit (15; 150) nur aktiviert ist, wenn der erste Treiber (123, 124, 125) und/oder der zweite Treiber (123, 124, 125) ein Signal auf den Bus (40) treibt.

8. Teilnehmerstation (10; 30; 100) für ein Bussystem (1), mit
einer Kommunikationssteuereinrichtung (11; 110) zum Steuern einer Kommunikation der Teilnehmerstation (10; 30; 100) mit mindestens einer weiteren Teilnehmerstation (10; 20; 30; 100) des Bussystems (1), und
einer Sende-/Empfangseinrichtung (12; 120) nach einem der vorangehenden Ansprüche zum Senden von Nachrichten (45; 47) auf einen Bus (40) des Bussystems (1) und zum Empfangen von Nachrichten (45; 47) von dem Bus (40).

9. Teilnehmerstation (10; 30; 100) nach Anspruch 8,
wobei die Kommunikationssteuereinrichtung (110) oder die Sende-/Empfangseinrichtung (12; 120) einen Block (116; 152) aufweist, welcher ausgestaltet ist, einen Zustandswechsel eines vom Bus (40) empfangenen Signals von dem dominanten Buszustand (402) zu dem rezessiven Buszustand (401) zu erfassen,
wobei die Schwingungsreduktionseinheit (15; 150) ausgestaltet ist, den Kurzschluss zwischen den Busadern (41, 42) in Abhängigkeit von dem Erfassungsergebnis des Blocks (116; 141) zu erzeugen.

10. Teilnehmerstation (100) nach Anspruch 8 oder 9, wobei die Kommunikationssteuereinrichtung (110) ausgestaltet ist, ein Signal (TxD) an die Sende-/Empfangseinrichtung (120) zu senden, welches die Sende-/Empfangseinrichtung (120) als Grundlage für die Signale (CAN_H, CAN_L) für die Busadern (41, 42) verwendet, und das Signal (TxD) mit einem von der Sende-/Empfangseinrichtung (120) vom Bus (40) empfangenen Signal (RxD) zur Erzeugung eines Steuersignals zu vergleichen, und wobei die Kommunikationssteuereinrichtung (110) ausgestaltet ist, das Steuersignal zur Steuerung der Schwingungsreduktionseinheit (150) an die Sende-/Empfangseinrichtung (120) auszugeben.

11. Bussystem (1), mit
einem Bus (40), und
mindestens zwei Teilnehmerstationen (10; 30; 100), welche über den Bus (40) derart miteinander verbunden sind, dass sie miteinander kommunizieren können und von denen mindestens eine Teilnehmerstation (10; 30; 100) eine Teilnehmerstationen (10; 30; 100) nach einem der Ansprüche 8 bis 10 ist.

## Claims

1. Transmission/reception device (12; 120) for a bus system (1), having
a first driver (123, 124, 125) for driving a first signal (CAN_H) for a first bus wire (41) of a bus (40) of the bus system (1), which bus system (1) at least intermittently ensures exclusive collision-free access by a subscriber station (10, 20, 30) to the bus (40) of the bus system (1),
a second driver (123, 124, 127) for driving a second signal (CAN_L) for the second bus wire (42) of the bus (40), and
an oscillation reduction unit (15; 150) configured to produce a short between the bus wires at least during a change of state of the signal (CAN_H, CAN_L) on at least one of the bus wires (41, 42) from a dominant bus state (402) to a recessive bus state (401),
**characterized in that** a controllable current source (123) and a cascode transistor (124) are used to drive a signal (CAN_H) for the first bus wire (41) via a first current mirror (125) and a first output stage transistor (126),
wherein the first current mirror (125) is implemented as a PMOS current mirror,
wherein there is provision for a first polarity reversal protection diode (129) for the first current mirror (125), said polarity reversal protection diode being connected between the first current mirror (125) and a connection (43) to the voltage supply,
wherein the anode of the first polarity reversal protection diode (129) is connected to the connection (43),
wherein the controllable current source (123) and the cascode transistor (124) are used to drive a signal (CAN_L) for the second bus wire (42) via a second current mirror (127) and a second output stage transistor (128),
wherein the second current mirror (127) is implemented as an NMOS current mirror,
wherein there is provision for a second polarity reversal protection diode (130) for the second current mirror (127), between a source connection of the second output stage transistor (128) and the connection (122) for the second bus wire (42).

2. Transmission/reception device (12; 120) according to Claim 1, wherein the oscillation reduction unit (15; 150) has
a transistor (151) connected to a connection between the first driver (123, 124, 125) and the first bus wire (41) and connected to a further connection between the second driver (123, 124, 127) and the second bus wire (42), and
an actuating block (152) configured to at least turn on the transistor (151) during a change of state of the signal (CAN_H, CAN_L) on at least one of the bus wires (41, 42) from a dominant bus state (402) to a recessive bus state (401).

3. Transmission/reception device (12; 120) according to Claim 1 or 2, wherein the actuating block (152) is also configured to detect a change of state of the signal on at least one bus wire (41, 42) from the dominant bus state (402) to the recessive bus state (401).

4. Transmission/reception device (12; 120) according to one of the preceding claims, wherein the oscillation reduction unit (15; 150) has a transistor (151), which is configured as a high-voltage NMOS transistor, in order to produce the short.

5. Transmission/reception device (12; 120) according to one of the preceding claims, wherein the actuating block (152) is also configured to detect different phases of a communication on the bus (40) and to control the signal on at least one bus wire (41; 42) on the basis of the detected phase of the communication on the bus (40).

6. Transmission/reception device (12; 120) according to Claim 5,
wherein the actuating block (152) is configured to detect an end bit (454) that indicates the end of a message (45; 47), in order to detect the different phases of a communication on the bus (40), and/or
wherein the actuating block (152) is configured to control the signal on at least one bus wire (41; 42) following the conclusion of an arbitration phase (451; 453) of the communication.

7. Transmission/reception device (12; 120) according to one of the preceding claims, wherein the oscillation reduction unit (15; 150) is configured such that the oscillation reduction unit (15; 150) is activated only if the first driver (123, 124, 125) and/or the second driver (123, 124, 125) drives a signal onto the bus (40) .

8. Subscriber station (10; 30; 100) for a bus system (1), having
a communication control device (11; 110) for controlling a communication of the subscriber station (10; 30; 100) with at least one further subscriber station (10; 20; 30; 100) of the bus system (1), and
a transmission/reception device (12; 120) according to one of the preceding claims for transmitting messages (45; 47) to a bus (40) of the bus system (1) and for receiving messages (45; 47) from the bus (40).

9. Subscriber station (10; 30; 100) according to Claim 8,
wherein the communication control device (110) or the transmission/reception device (12; 120) has a block (116; 152) that is configured to detect a change of state of a signal received from the bus (40) from the dominant bus state (402) to the recessive bus state (401),
wherein the oscillation reduction unit (15; 150) is configured to produce the short between the bus wires (41, 42) on the basis of the detection result of the block (116; 141).

10. Subscriber station (100) according to Claim 8 or 9, wherein the communication control device (110) is configured to transmit a signal (TxD) to the transmission/reception device (120), which signal is used by the transmission/reception device (120) as a basis for the signals (CAN_H, CAN_L) for the bus wires (41, 42), and to compare the signal (TxD) with a signal (RxD) received by the transmission/reception device (120) from the bus (40) in order to generate a control signal, and wherein the communication control device (110) is configured to output the control signal to the transmission/reception device (120) in order to control the oscillation reduction unit (150).

11. Bus system (1), having
a bus (40), and
at least two subscriber stations (10; 30; 100) that are connected to one another via the bus (40) such that they can communicate with one another, and at least one subscriber station (10; 30; 100) of which is a subscriber station (10; 30; 100) according to one of Claims 8 to 10.

## Revendications

1. Dispositif d'émission/réception (12 ; 120) pour un système de bus (1), comportant
un premier pilote (123, 124, 125) pour piloter un premier signal (CAN_H) destiné à un premier conducteur de bus (41) d'un bus (40) du système de bus (1), ledit système de bus (1) garantissant au moins temporairement un accès exclusif et sans collision d'une station d'abonné (10, 20, 30) au bus (40) du système de bus (1),
un second pilote (123, 124, 127) destiné à piloter un second signal (CAN_L) destiné au second conducteur de bus (42) du bus (40), et
une unité de réduction des oscillations (15 ; 150) qui est conçue pour générer un court-circuit entre les conducteurs de bus au moins pendant une transition d'état du signal (CAN_H, CAN_L) sur au moins l'un des conducteurs de bus (41, 42) d'un état de bus dominant (402) à un état de bus récessif (401),
**caractérisé en ce qu'**un signal (CAN_H) destiné au premier conducteur de bus (41) est piloté par l'intermédiaire d'un premier miroir de courant (125) et d'un premier transistor d'étage de sortie (126) à l'aide d'une source de courant réglable (123) et d'un transistor cascode (124),
dans lequel le premier miroir de courant (125) est mis en œuvre sous la forme d'un miroir de courant PMOS,
dans lequel il est prévu pour le premier miroir de courant (125) une première diode de protection contre l'inversion de polarité (129), qui est connectée à l'alimentation en tension entre le premier miroir de courant (125) et une borne (43),
dans lequel l'anode de la première diode de protection contre l'inversion de polarité (129) est connectée à la borne (43),
dans lequel un signal (CAN_L) destiné au second conducteur de bus (42) est piloté par l'intermédiaire d'un second miroir de courant (127) et d'un second transistor d'étage de sortie (128) à l'aide de la source de courant réglable (123) et du transistor cascode (124), dans lequel le second miroir de courant (127) est mis en œuvre sous la forme d'un miroir de courant NMOS,
dans lequel il est prévu pour le second miroir de courant (127) une deuxième diode de protection contre l'inversion de polarité (130) entre une borne de source du deuxième transistor d'étage de sortie (128) et la borne (122) destinée au second conducteur de bus (42).

2. Dispositif d'émission/réception (12 ; 120) selon la revendication 1, dans lequel l'unité de réduction des oscillations (15 ; 150) comporte
un transistor (151) qui est connecté à une borne entre le premier pilote (123, 124, 125) et le premier conducteur de bus (41) et qui est connecté à une autre borne entre le second pilote (123, 124, 127) et le second conducteur de bus (42), et
un bloc de commande (152) qui est conçu pour au moins rendre passant le transistor (151) pendant une transition d'état du signal (CAN_H, CAN_L) sur au moins l'un des conducteurs de bus (41, 42) d'un état de bus dominant (402) à un état de bus récessif (401).

3. Dispositif d'émission/réception (12 ; 120) selon la revendication 1 ou 2, dans lequel le bloc de commande (152) est en outre conçu pour détecter une transition d'état du signal sur au moins un conducteur de bus (41, 42) de l'état de bus dominant (402) à l'état de bus récessif (401).

4. Dispositif d'émission/réception (12 ; 120) selon l'une quelconque des revendications précédentes, dans lequel l'unité de réduction des oscillations (15 ; 150) comporte un transistor (151) qui est conçu sous la forme d'un transistor NMOS haute tension pour générer le court-circuit.

5. Dispositif d'émission/réception (12 ; 120) selon l'une quelconque des revendications précédentes, dans lequel le bloc de commande (152) est en outre conçu pour détecter différentes phases d'une communication sur le bus (40) et pour commander le signal sur au moins un conducteur de bus (41 ; 42) en fonction de la phase détectée de la communication sur le bus (40).

6. Dispositif d'émission-réception (12 ; 120) selon la revendication 5,
dans lequel le bloc de commande (152) est conçu pour détecter un bit de fin (454) indiquant la fin d'un message (45 ; 47) afin de détecter les différentes phases d'une communication sur le bus (40), et/ou
dans lequel le bloc de commande (152) est conçu pour commander le signal sur au moins un conducteur de bus (41 ; 42) après l'achèvement d'une phase d'arbitrage (451 ; 453) de la communication.

7. Dispositif d'émission/réception (12 ; 120) selon l'une quelconque des revendications précédentes, dans lequel l'unité de réduction des oscillations (15 ; 150) est conçue de telle sorte que l'unité de réduction des oscillations (15 ; 150) ne soit activée que lorsque le premier pilote (123, 124, 125) et/ou le second pilote (123, 124, 125) pilote un signal sur le bus (40).

8. Station d'abonné (10 ; 30 ; 100) destinée à un système de bus (1), comprenant
un dispositif de commande de communication (11 ; 110) destiné à commander une communication de la station d'abonné (10 ; 30 ; 100) avec au moins une autre station d'abonné (10 ; 20 ; 30 ; 100) du système de bus (1), et un dispositif d'émission/réception (12 ; 120) selon l'une quelconque des revendications précédentes destiné à émettre des messages (45 ; 47) sur un bus (40) du système de bus (1) et à recevoir des messages (45 ; 47) en provenance du bus (40).

9. Station d'abonné (10 ; 30 ; 100) selon la revendication 8,
dans laquelle le dispositif de commande de communication (110) ou le dispositif d'émission-réception (12 ; 120) comporte un bloc (116 ; 152) qui est conçu pour détecter une transition d'état d'un signal reçu en provenance du bus (40) de l'état de bus dominant (402) à l'état de bus récessif (401),
dans laquelle l'unité de réduction des oscillations (15 ; 150) est conçue pour générer le court-circuit entre les conducteurs de bus (41, 42) en fonction du résultat de détection du bloc (116 ; 141).

10. Station d'abonné (100) selon la revendication 8 ou 9, dans laquelle le dispositif de commande de communication (110) est conçu pour émettre un signal (TxD) vers le dispositif d'émission/réception (120), que le dispositif d'émission/réception (120) utilise comme base pour les signaux (CAN_H, CAN_L) destinés aux conducteurs de bus (41, 42), et pour comparer le signal (TxD) à un signal (RxD) reçu par le dispositif d'émission/réception (120) en provenance du bus (40) afin de générer un signal de commande, et dans lequel le dispositif de commande de communication (110) est conçu pour délivrer le signal de commande au dispositif d'émission/réception (120) afin de commander l'unité de réduction des oscillations (150).

11. Système de bus (1), comprenant
un bus (40), et
au moins deux stations d'abonnés (10 ; 30 ; 100) qui sont reliées entre elles par le bus (40) de manière à pouvoir communiquer entre elles et dont au moins une station d'abonné (10 ; 30 ; 100) est une station d'abonné (10 ; 30 ; 100) selon l'une quelconque des revendications 8 à 10.
